# EUROPEAN PATENT APPLICATION

(11) **EP 4 718 986 A1**
(43) Date of publication of application: **01.04.2026**
(21) Application number: 24202729.0
(22) Date of filing: 26.09.2024
(51) Int. Cl.: H10D 64/01, H10B 51/20

(54) **A REPLACEMENT METAL GATE FIRST METHOD FOR FABRICATING A FERROELECTRIC MEMORY DEVICE**

(71) Applicant: Imec VZW, 3001 Leuven (BE)
(72) Inventor: Izmailov, Roman, 3000 Leuven (BE); Walke, Amey Mahadev, 3001 Heverlee (BE); Yasin, Farrukh, 3000 Leuven (BE)
(74) Representative: Roth, Sebastian

(57) **Abstract**

The present disclosure relates to a method for fabricating a memory device, for example, a ferroelectric memory device. Further, the disclosure relates to a structure suitable for building the memory device. The method of this disclosure comprises a replacement metal gate (RMG) process, wherein sacrificial layers of a stack are replaced with metal layers. The RMG process is performed before a process of forming memory structures in memory holes, which extend through the stack. In this way, the memory structures can be formed with low thermal budget, for instance, at temperatures below 400°C, which is of benefit particularly for ferroelectric layers of memory structures of a ferroelectric memory device.

## Description

### TECHNICAL FIELD

The present disclosure relates to a method for fabricating a memory device, for example, a ferroelectric memory device. The disclosure further relates to a structure that is suitable for building such a memory device. The method comprises one or more replacement metal gate (RMG) or replacement metal electrode (RME) process steps, which are performed before one or more process steps of forming a memory structure of the memory device, for example, a ferroelectric memory structure. Accordingly, the disclosure refers to a RMG-first method for fabricating the memory device.

### BACKGROUND

Three-dimensional (3D) non-volatile semiconductor memory devices, for instance 3D NAND flash memory devices, are conventionally fabricated using a fabrication method referred to as RMG last in this disclosure. In this conventional fabrication method, the memory structures (also called memory elements) are formed first, specifically in vertical memory holes, before RMG process steps to form metal word lines are carried out last.

However, this conventional fabrication method, particularly the order of processing, is not suitable for the fabrication of many other memory devices, in particular, not for ferroelectric-based nonvolatile memory devices. For instance, the conventional fabrication method is unsuitable for fabricating a 3D ferroelectric field effect transistor (FeFET), or a 3D ferroelectric flash memory, or a 3D ferroelectric random access memory (FeRAM). This is the case, because the RMG process steps, which are performed last in the conventional fabrication method, can, for example, create unwanted stress in the previously fabricated channel layer(s) and ferroelectric layer(s) of the memory elements, which are arranged near the RMG layers. This unwanted stress can, for example, change phase ratios in the ferroelectric layer(s), thereby affecting properties such as remnant polarization and coercive field, and may negatively impact the performance of the ferroelectric memory device such as memory window, endurance, and retention. Generally, for many types of memory devices, the conventional fabrication method with the RMG last approach may negatively impact the performance of the memory device.

### SUMMARY

In view of the above, this disclosure has the objective to provide an alternative fabrication method, which is suitable for fabricating a larger variety of memory devices, in particular, is also suitable for making ferroelectric memory devices. A particular objective is to avoid, or at least significantly reduce, unwanted stress on the memory structures of the memory device, especially on possibly used ferroelectric layers.

These and other objectives are achieved by the solutions of this disclosure, which are described in the independent claims. Advantageous implementations are described in the dependent claims.

The solutions of this disclosure propose a fabrication method with a RMG-first or RME-first approach. That is, with one or more RMG or RME process steps, which respectively create metal gates or metal electrodes before forming memory structures for the memory device. In particular, the RMG or RME process steps are performed before deposition of ferroelectric layers used in the memory structures.

A first aspect of this disclosure provides method for fabricating a memory device, particularly a ferroelectric memory device, the method comprising: depositing a stack of a plurality of dielectric layers and sacrificial layers, which are alternatingly arranged one on the other along a stacking direction, wherein the sacrificial layers are made of a first sacrificial material; forming a plurality of memory holes in the stack, wherein each memory hole extends through each layer of the stack; filling each memory hole with a second sacrificial material; shaping the stack to have a staircase structure at opposite outer sides, wherein the staircase structure is formed by the shaped stack having multiple concentric layer pairs of a dielectric layer and a sacrificial layer, wherein a respective width of the layer pairs decreases continuously along the stacking direction; after forming the memory holes, replacing each sacrificial layer of the stack with a respective metal layer; and after replacing the sacrificial layers, replacing the second sacrificial material in each memory hole with a respective memory structure; wherein each memory structure forms, in combination with the plurality of metal layers, a plurality of memory cells.

Notably, unless explicitly mentioned, no order of the above method steps should be inferred by their order of description. In particular, while the shaping of the stack preferably occurs after filling the memory holes, it is also possible to shape the stack before forming and filling the memory holes. The replacing of the sacrificial layers is done at least after forming the memory holes - to avoid, e.g., etching of metal - preferably after filling the memory holes, more preferably after filling the memory holes and shaping the stack.

In the fabrication method of the first aspect, one or more RMG or RME process steps - which implement the replacement of the sacrificial layers with the metal layers to form metal gates or metal electrodes depending on the type of the memory device - are performed before forming the memory structures, which are used for the storage part of the memory cells. Notably, the disclosure may at some places generally refer to RMG process steps, even if metal electrodes and not metal gates are formed from the metal layers. In such cases, it would be more precise to refer to one or more RME process steps instead of one or more RMG process steps. However, the distinction between RMG and RME is outside the scope of this disclosure. Accordingly, the fabrication method of the first aspect is suitable for fabricating more memory devices than the conventional fabrication method, including also ferroelectric memory devices. For instance, the fabrication method of the first aspect is suitable for fabricating a FeRAM, a FeFET, or a ferroelectric flash memory device. However, the fabrication method is also suitable for fabricating any other memory device, which may be fabricated with RMG or RME process steps, for example, also memory devices without any ferroelectric functionality.

Moreover, shaping the stack into the staircase structure provides additional benefits in terms of contacting the memory cells, which comprise the memory structures and metal layers, in particular, contacting the metal layers to be able to address the memory cells in the memory device. In this respect, after the staircase structure is formed and before the RMG or RME process steps are carried out, a dielectric fill and planarization step may be beneficial, in order to provide a better supporting structure when removing the first sacrificial material of the sacrificial layers, in order to replace the removed layers with the metal layers. The staircase structure means that the stack after shaping has a staircase-shape at each of two opposite sides - wherein these sides may be opposite with respect to the direction along which the width of the layers is measured. This direction of measuring width may be perpendicular to the stacking direction, i.e., in-plane of the layers. The stack will thus become narrower towards its top, e.g., with increased distance from a substrate over which the stack is formed. The staircase structure has steps, wherein each step is formed by one of the layer pairs. Step heights and widths may all be the same, but may vary as well.

In an implementation, the memory structures are formed in the memory holes at a temperature below 400 °C, and/or the memory structures are formed in the memory holes and, subsequently, are not exposed to temperatures above 400 °C.

That is, the memory structures only experience a low thermal budget (TB), which further helps to avoid, or at least significantly reduce, unwanted stress and damage. The memory structures, and thus the memory cells in the final memory device, may exhibit a better performance and may have better defined characteristics as achievable with the conventional fabrication method. For instance, in case that ferroelectric layers are included in the memory structures, relevant properties of these ferroelectric layers, such as remnant polarization and coercive field, and resulting memory performance characteristics such as memory window, endurance, and retention, are not or at least less affected than in the conventional fabrication method. Furthermore, other structures present on the memory device before formation of the memory structures, for instance, peripheral logic structures and metallization layers, also only experience a low TB, which can allow the use of lower resistive metals, such as copper, and temperature-sensitive logic devices.

The RMG or RME process steps, i.e. the one or more steps effecting the replacement of the sacrificial layers with the metal layers, which occur before forming the memory structures, and memory structure formation steps may notably involve also temperatures above 400°C.

In an implementation, the memory structures are formed in the memory holes and, subsequently, are not exposed to mechanical stress due to removal of materials adjacent to memory structures.

This may further improve the definition and performance of the memory structures, and thus also of the memory cells of the memory device.

In an implementation, the memory structures comprise an oxide semiconductor material.

The use of the oxide semiconductor material may allow skipping a high-temperature channel activation anneal, which may benefit the performance of the memory device.

In an implementation, the memory structures comprise a ferroelectric material, for example, hafnium zirconium oxide (HZO).

HZO may offer low-temperature options with crystallization temperatures below 400°C, which may benefit the performance of the memory device.

In an implementation, a memory cell comprises a ferroelectric capacitor or a ferroelectric field effect transistor, or is a flash memory cell or a ferroelectric flash memory cell.

That is, a ferroelectric memory device can be fabricated with the method of the first aspect, without performance degradation as with the RMG last approach of the conventional fabrication method.

In an implementation, the ferroelectric material comprises HZO, for example, lanthanum doped HZO.

In an implementation, the method further comprises: after filling the memory holes and before replacing the sacrificial layers, forming one of more trenches in the stack, wherein each trench extends through each layer of the stack and is arranged between two or more of the memory holes; and after replacing the sacrificial layers, filling the one or more trenches with a dielectric, semiconducting or conducting material.

In an implementation, a portion of the stack is arranged between each trench and the two or more memory holes between which the trench is arranged.

The trenches facilitate the removal of the first sacrificial material, and thus improve the efficiency of the method.

In an implementation, the method further comprises: after forming the staircase structure, depositing planarizing material, for example, silicon oxide, on top of the staircase structure; wherein the thickness of the deposited planarizing material exceeds a step height difference between a top and bottom staircase level; and after depositing the planarizing material, flattening the surface of the structure through, for example, chemical mechanical planarization.

The planarizing material helps stabilizing the resulting intermediate structure (compared to without planarizing material), which facilitates the one or more RMG or RME process steps or other process steps like contact formation or patterning steps beyond the RMG or RME process steps.

In an implementation, the method further comprises: before replacing the second sacrificial material in each memory hole, forming a plurality of contact holes to the plurality of metal layers; and filling the plurality of contact holes with conducting or semiconducting material.

Thus, contact holes can be made early in the fabrication method of the first aspect, i.e., before forming the memory structures, which maybe beneficial.

In an implementation, the first sacrificial material comprises silicon nitride or another nitride.

In an implementation, replacing the sacrificial layers with the metal layers comprises selectively etching the first sacrificial material and/or depositing metal material to form the metal layers.

The etching of the first sacrificial material may be performed with an etch chemistry that does not affect the second sacrificial material.

In an implementation, the method further comprises: between selectively etching the first sacrificial material and depositing metal material to form the metal layers, forming one or more layers of the memory structure inside a cavity resulting from the etching, for example, by atomic layer deposition or area selective deposition; wherein the one or more memory layers comprise metal, semiconductor, ferroelectric, or dielectric material.

Notably, the cavity (or cavities) resulting from the etching is not the same as a memory hole, but refers to additional spaces in between the layers of the stack, after the sacrificial layers have been removed. In this way, for example, buffer layers can be formed that can potentially facilitate scaling of the size of the memory hole (less thickness deposited on the sidewall) and improve the stack properties (interface between metal gate and memory layers, for example, scavenging barrier layer).

In an implementation, the second sacrificial material comprises amorphous silicon.

In an implementation, replacing the second sacrificial material comprises selectively etching the second sacrificial material, for example, selectively etching the amorphous silicon with phosphoric acid and/or tetramethylammonium hydroxide.

In an implementation, the metal layers comprise one or more of: molybdenum; a composition comprising molybdenum and a molybdenum oxide; titanium nitride; a composition comprising ruthenium and titanium nitride; or tungsten.

A second aspect of this disclosure provides a structure suitable for building a memory device, particularly a ferroelectric memory device, the structure comprising: a stack of a plurality of metal layers and dielectric layers, which are alternatingly arranged one on the other along a stacking direction, wherein the stack has a shape of a staircase structure at opposite outer sides of the stack, wherein the shape of the staircase structure is formed by the stack having multiple concentric layer pairs of a dielectric layer and a sacrificial layer, wherein a respective width of the layer pairs decreases continuously along the stacking direction; and a plurality of memory holes in the stack, wherein each memory hole extends through each layer of the stack, and wherein each memory hole is filled with a sacrificial material, for example, amorphous silicon.

In an implementation, the structure of the second aspect further comprises a plurality of vertical contact holes that are formed through the stack and are filled with conducting or semiconducting material.

Vertical may relate to the stacking direction, i.e., the stacking direction may be vertical. The width of the layers of the stack may be horizontal.

The structure of the second aspect may have implementations that correspond to the implementations of the fabrication method of the first aspect. The structure of the second aspect is suitable for the proposed RMG-first approach of the fabrication method of the first aspect. Thus, the structure is suitable for ferroelectric memory devices. The structure of the second aspect and its implementations may provide the effects and advantages described above with respect to the method of the first aspect and its implementations.

In summary of the above aspects and implementations, a fabrication method for stress-sensitive 3D non-volatile memories, such as FeFET and FeRAM, is proposed. Such memory devices can benefit from the formation of metal layers (e.g. used as metal gates or metal electrodes) before the deposition of memory structures comprising one or more ferroelectric layers.

The method proposed in this disclosure is particularly suitable for fabricating 3D ferroelectric memory devices, since it involves using a RMG-first approach, for instance, with a back-end-of-line (BEOL) thermal budget, and accordingly uses a memory structure (e.g., ferroelectric) last approach. The formation of the metal layers in the presence of dummy memory hole plugs - which are made of or comprise the second sacrificial material - is further proposed. This is followed by the replacement of the sacrificial memory hole plugs by (low TB) memory structures, for instance, comprising ferroelectric and/or oxide semiconductor layers.

The proposed fabrication method ensures that any high stress inducing RMG process steps is finished before the deposition of the memory structures, particularly ferroelectric layers thereof, such that for instance the ferroelectric properties of these ferroelectric layers are not influenced by the mechanical stress induced by the RMG process.

### BRIEF DESCRIPTION OF THE DRAWINGS

The above described aspects and implementations are explained in the following description of embodiments with respect to the enclosed drawings:
- FIG. 1: shows a flow diagram of a fabrication method for making a memory device, for instance a ferroelectric memory device, according to this disclosure.
- FIGs. 2-14: illustrate steps, particularly resulting structures, of the fabrication method according to this disclosure.
- FIGs. 15-17: show additional steps that can be used for contact formation in the fabrication method according to this disclosure.

### DETAILED DESCRIPTION OF EMBODIMENTS

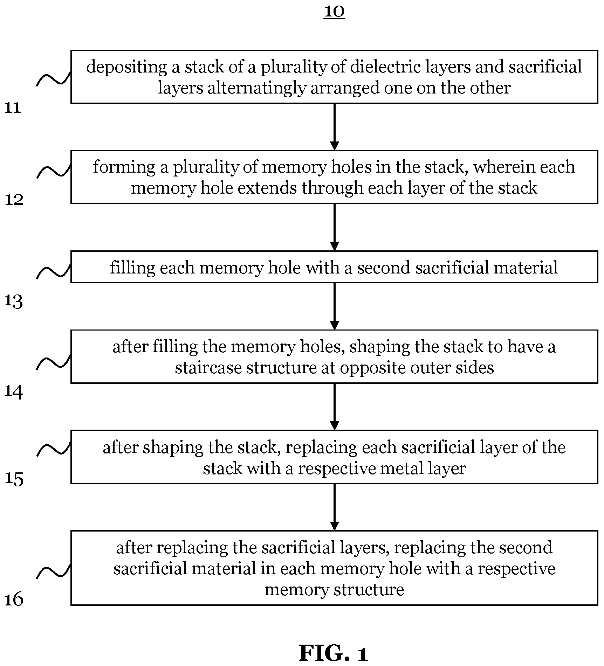

FIG. 1 shows a flow diagram of a fabrication method 10 according to this disclosure, wherein the method 10 is suitable for making a memory device. The method 10 can be used to fabricate a ferroelectric memory device. The steps of the method 10 may be preceded and/or may be followed by additional steps for fabricating the memory device completely. These additional steps may depend on the memory device type. The method 10 maybe performed as a process flow of consecutive process steps in a semiconductor manufacturing line or the like.

The method 10 comprises a step 11 of depositing a stack of a plurality of dielectric layers and sacrificial layers, which are alternatingly arranged one on the other along a stacking direction. The layers may be deposited, one after the other, on top of each other, so as to form the stack. Each dielectric layer may be followed by a sacrificial layer deposited on it. Preferably, the first layer and the last layer is respectively a dielectric layer, but this is not mandatory. The layer-by-layer deposition, e.g. implemented as atomic layer deposition (ALD) or chemical vapor deposition (CVD), of the stack also defines the stacking direction. The stacking direction is typically perpendicular to the plane of each layer, and may be parallel to a vertical axis (or z-axis in a coordinate system). The sacrificial layers are made of a first sacrificial material, which may be or may comprise a nitride, for example, silicon nitride. The dielectric layers may be or may comprise an oxide, for instance, silicon oxide.

The method 10 further comprises a step 12 of forming a plurality of memory holes in the stack. Each of the memory holes extends through each layer of the stack. For instance, the memory holes may extend parallel to the stacking direction, so typically perpendicular to the plane of each layer. Thus, they may be referred to as vertical memory holes. However, it is also possible that the memory holes extend with a respective angle to the stacking direction, i.e., oblique to the planes of the layers of the stack.

The method 10 further comprises a step 13 of filling each memory hole with a second sacrificial material, for instance, the second sacrificial material comprising amorphous silicon.

Before or after the steps 12 and 13 of forming and filling the memory holes, the method 10 further comprises a step 14 of shaping the stack to have a staircase structure at opposite outer sides. In particular, the staircase structure is formed by the shaped stack having multiple concentric layer pairs, wherein each layer pair comprises one of the dielectric layers and one of the sacrificial layers. Further, a respective width of the layer pairs decreases continuously along the stacking direction. The width of the layers is in this disclosure to be understood as their extension perpendicular to the stacking direction, which may be parallel to a horizontal axis (or x-axis in a coordinate system). The thickness of the layers would be in stacking direction (or z-axis). That is, the width of the stack as a whole, from one of its outer sides to the other relative to this width, also decreases along the stacking direction. The stack may thus resemble a triangular structure, when viewed in a cross-section, or a pyramid structure when viewed in perspective.

After, for example, the steps 12 and 13 of forming and filling the memory holes 31, the method 10 comprises a step 15 of replacing each sacrificial layer of the stack with a respective metal layer. This step 15 may be implemented by one of more RMG process steps. The metal layers replacing the sacrificial layers may be referred to as replacement metal gates, used as gates of the memory cells in the memory device, or replacement metal electrodes, used as capacitor metal plates of the memory cells in the memory device.

After the step 15 of replacing the sacrificial layers, the method comprises a step 16 of replacing the second sacrificial material in each memory hole with a respective memory structure. Each memory structure forms, in combination with the plurality of metal layers, a plurality of memory cells. The memory structures may be or comprise memory (storage) elements for the functioning of the memory cells, while the metal layers may be metal gates or metal electrodes. The memory structure, per se, of various memory devices, like a 3D FeFET or FeRAM, are known to the skilled person.

It can be seen from the steps of the method 10, that the memory structures (may also be called memory elements) are formed after the RMG or RME process steps performed for replacing the sacrificial layers with the metal layers. This order brings about the above-described advantages, and makes the method 10 especially suitable for fabricating ferroelectric memory devices, without degrading the ferroelectric layers. However, also other non-ferroelectric memory devices can be produced with the method 10, for example, NAND flash memory devices or DRAM memory devices, or the like.

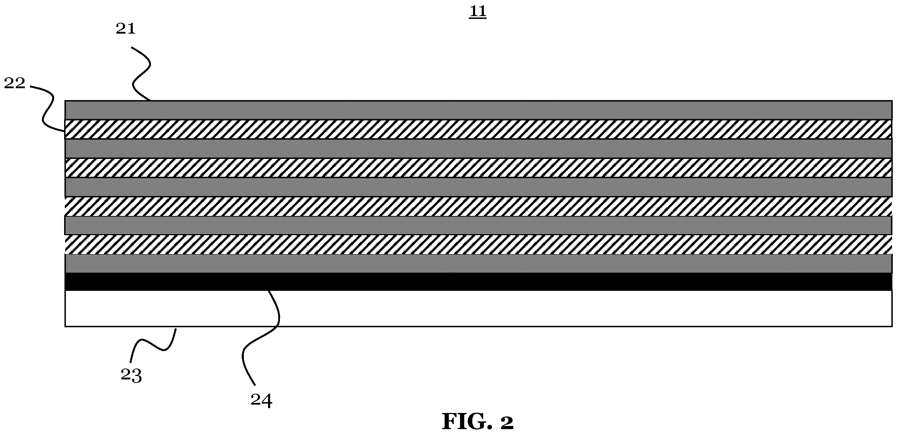

Illustrative examples of the steps of the method 10 shown in FIG. 1 are shown, together with additional optional steps, in the FIGs. 2-14. The FIGs. 2-14 show at least parts of an exemplary process flow for producing the memory device.

FIG. 2 illustrates the result of step 11 of the method 10 of FIG. 1. That is, FIG. 2 shows the stack of the plurality of dielectric layers 21 and sacrificial layers 22, which are alternatingly arranged one on the other along the stacking direction (which is vertical in FIG. 2). The layers 21, 22 have been deposited one upon another, particularly, one after the other. FIG. 2 also shows that the stack can be deposited above a substrate 23, and that a layer 24 comprising CMOS periphery for the memory device may be arranged between the stack and the substrate 23. The substrate 23 may be a substrate layer or a wafer. In an example, the dielectric layers 21 are (silicon) oxide layers, and the sacrificial layers 22 are (silicon) nitride layers.

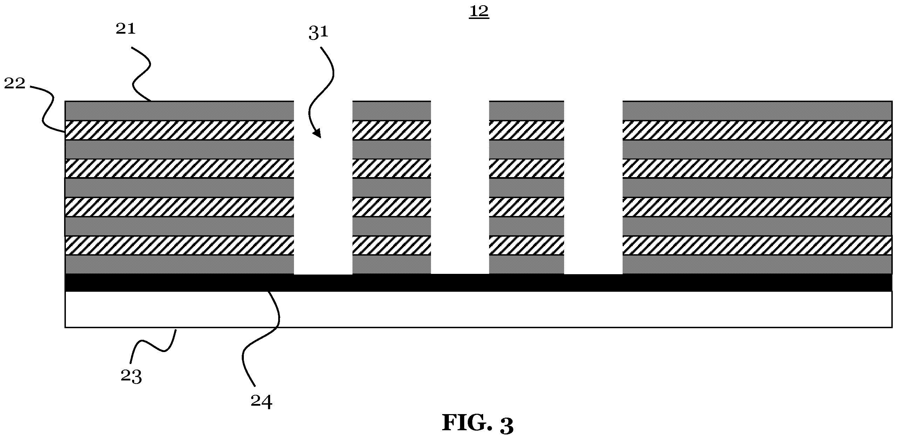

FIG. 3 illustrates the result of step 12 of the method 10 shown in FIG. 1. That is, FIG. 3 shows a plurality of memory holes 31, wherein each memory hole 31 extends through all the dielectric layers 21 and all the sacrificial layers 22 of the stack. The memory holes 31 may extend parallel to the stacking direction, as illustrated. The memory holes 31 may end/land on the CMOS periphery layer 24, as illustrated, or one the substrate 23.

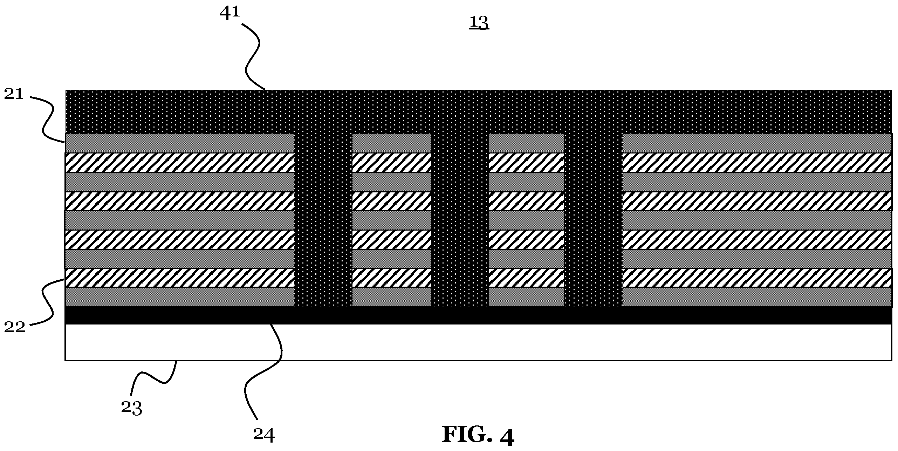

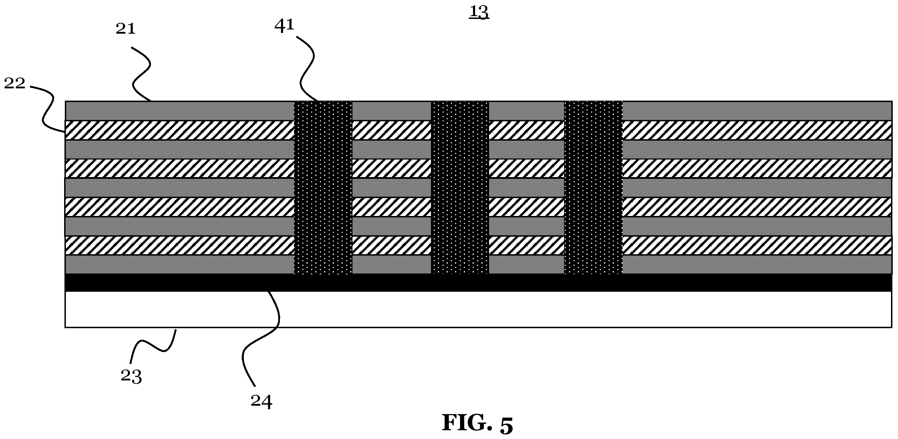

The FIGs. 4 and 5 illustrate the result of step 13 of the method 10. That is, the FIGs. 4 and 5 show that each memory hole 31 is filled with the second sacrificial material 41. The sacrificial material 41 may first be deposited and may thereby form dummy memory hole plugs, as shown in FIG. 4. Chemical-mechanical polishing (CMP) maybe performed to even the top surface of the second sacrificial material 41. FIG. 5 shows the isolated memory hole plugs of the second sacrificial material 41 after etch back, i.e., removing all of the second sacrificial material 41 that is on top of the stack.

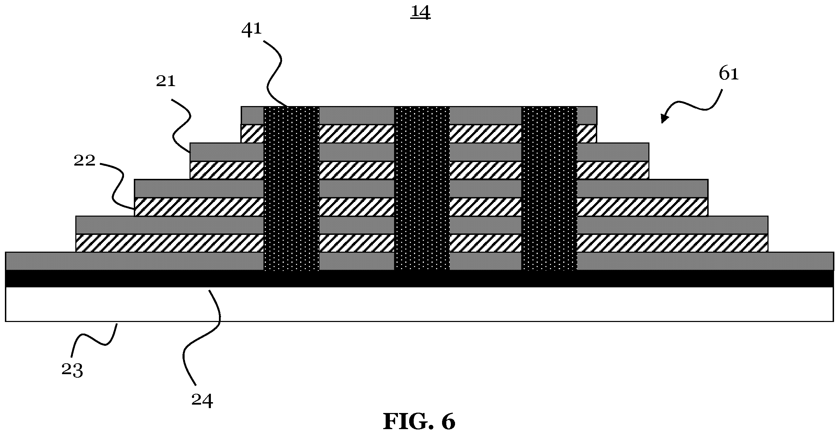

FIG. 6 illustrates the result of step 14 of the method 10 shown in FIG. 1. That is, FIG. 6 shows that the stack has been shaped to have a staircase structure 61 at its two outer sides (left and right side in FIG. 6). It can be seen that the staircase structure 61 is composed by multiple layer pairs of the shaped stack. Each layer pair consists of a dielectric layer 21 and a sacrificial layer 22. The dielectric layer 21 may be arranged on the sacrificial layer 22 in each layer pair, i.e., the sacrificial layer 22 may be the lower layer of each layer pair (that is closer to the substrate 23). The layer pairs are concentrically arranged on another, but have different width (i.e. different extensions perpendicular to the stacking direction as described above; in FIG. 6 the width is horizontal). As shown, the respective width of the layer pairs decreases continuously along the stacking direction (towards the top of the stack, i.e., away from the substrate 23). The stack thus narrows along the stacking direction, that is, narrows towards its top, that is, going away from the substrate 23. The result is a triangular-like or pyramid-like shape of the stack.

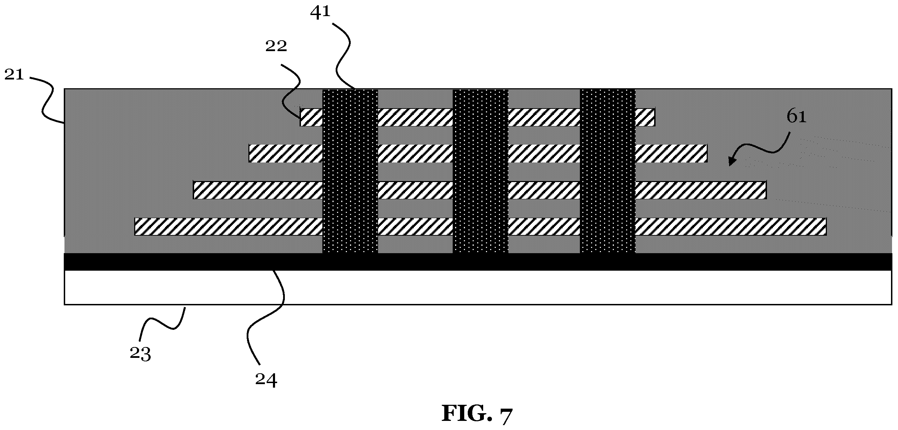

FIG. 7 shows the result of an optional dielectric fill and planarization step that may be carried out next (wherein planarization may comprise CMP and etch back). The staircase 61 can be covered in this step with the dielectric, for instance, oxide. Preferably, the dielectric material for the fill corresponds to that of the dielectric layers 21. The dielectric fill and planarization may be beneficial to provide a supporting structure, before later removing the first sacrificial material of the sacrificial layers 22 (part of step 16 of method 10).

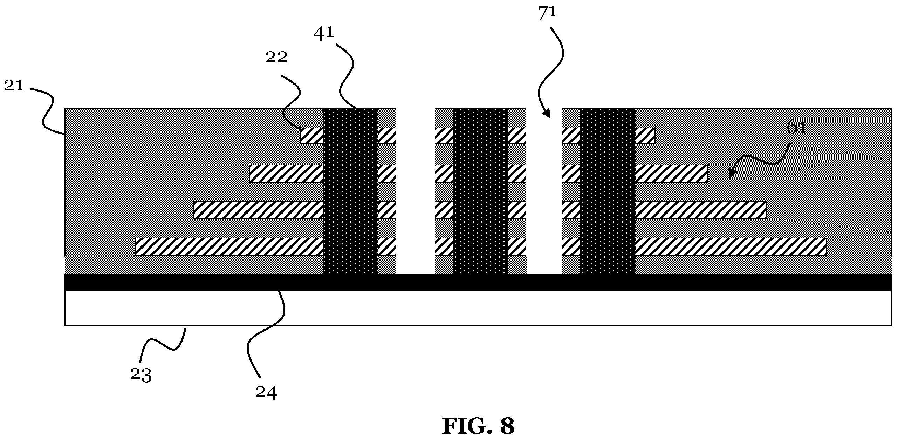

FIG. 8 shows the result of an optional step of forming one of more trenches 71 in the stack. Each trench 71 is formed such that it extends through each layer 21, 22 of the stack. For instance, the trenches 71 extend parallel to the stacking direction, but this is not a must similar as for the memory holes 31. Each trench 71 is arranged between two or more of the memory holes 31. The trenches 71 may facilitate the removal and replacement of the first sacrificial material.

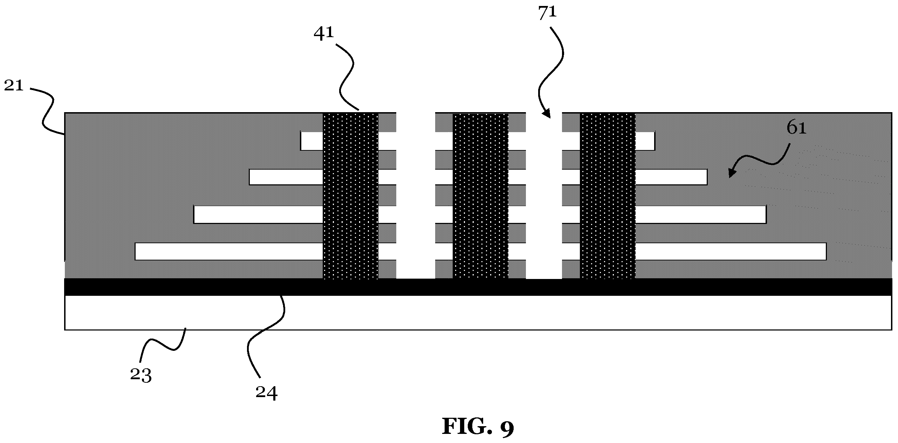

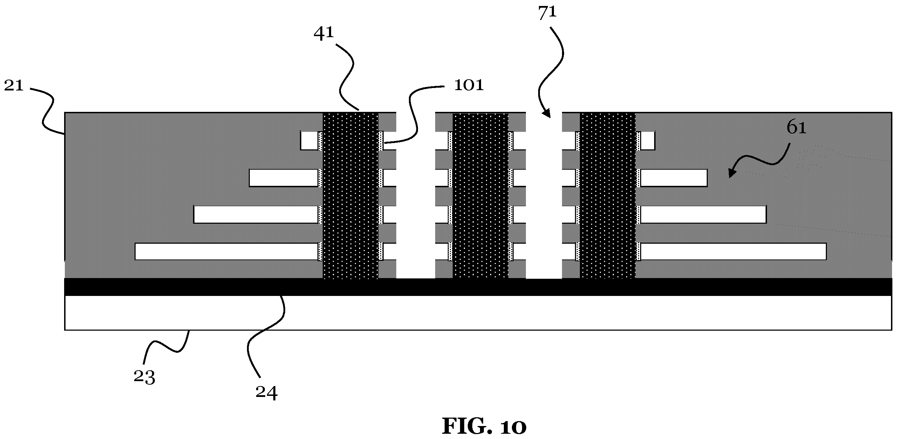

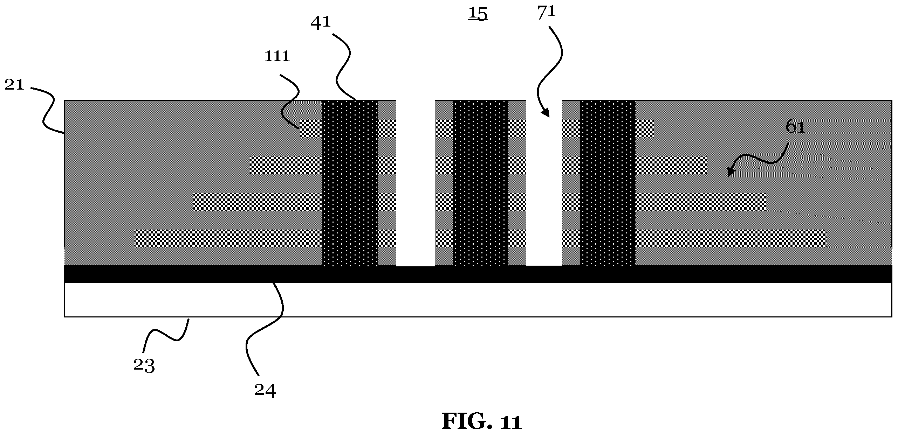

The FIGs. 9, 10 and 11 show the result of step 15 of the method 10. Thereby, FIG. 10 is optional. FIG. 11 is shown in direct continuation of FIG. 9, but could also continue the intermediate structure shown in FIG. 10.

FIG. 9 shows that the first sacrificial material of the sacrificial layers 22 is removed. This may be done by selectively etching the first sacrificial material. The dummy memory hole plugs of the second sacrificial material 41 should be selective to the etch chemistry. That is, the first sacrificial material should be etched by the etch chemistry, but not the second sacrificial material 41. As an example, the second sacrificial material 41 maybe amorphous silicon (a-Si) and the etch chemistry may be hot H₃PO₄. Beneficially, the dummy memory hole plugs may also serve an anchoring purpose in the memory array area, i.e., in the area where the memory cells will be formed. The staircase structure 61 may be held stable by the dielectric material filled in the step described with respect to FIG. 7.

FIG. 10 shows that optionally, after FIG. 9, a step of forming one or more layers 101 of the memory structure inside at least one cavity resulting from the etching may be done. The one or more layers 101 may be formed, for example, by atomic layer deposition (ALD) or area selective deposition (ASD). In the example provided in FIG. 10, one or more layers 101 of the memory structure are selectively deposited by ASD on the surface of the second sacrificial material 41 exposed inside the cavity. For example, the one or more memory layers 101 can comprise metal, semiconductor, ferroelectric, or dielectric material, or a high-k liner. A cavity is different from the memory hole 31 itself, and may be a space in between the layers of the stack, for instance, next to the plugged memory holes and/or next to the trenches 71, as shown.

FIG. 11 shows that after the step 15 is complete, wherein this step 15 may further comprise depositing metal material to form the metal layers 111, the metal layers 111 have replaced the sacrificial layers 22 in the stack. The deposition of the metal material may be by ALD or ASD. As mentioned before, the structure in FIG. 11 could additionally include the one or more layers 101 shown in FIG. 10.

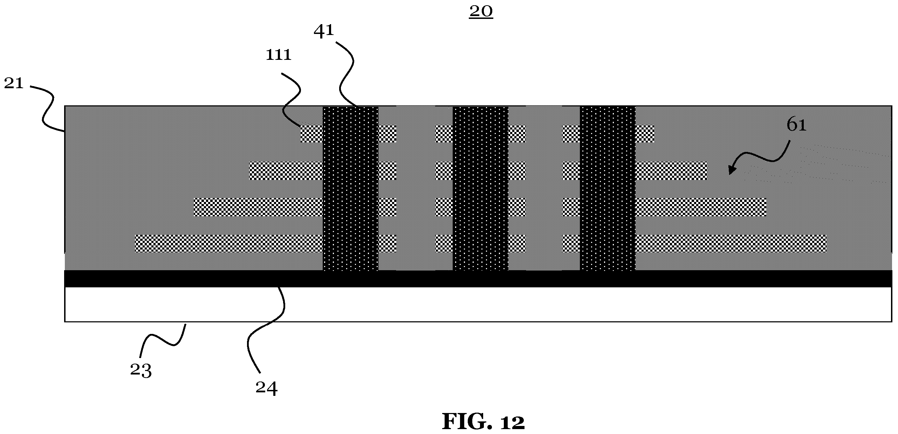

FIG. 12 shows a step of refilling the trenches 71, which may include depositing material, followed by planarization, e.g., CMP. A first refill option may be to deposit dielectric material, for instance, oxide only. A second refill option (not shown) may be to deposit the dielectric material, and additionally deposit a metal (e.g., for BEOL contacts to the CMOS periphery in layer 24). Notably, FIG. 12 shows a structure 20, which is suitable for building a memory device, particularly a ferroelectric memory device, according to this disclosure.

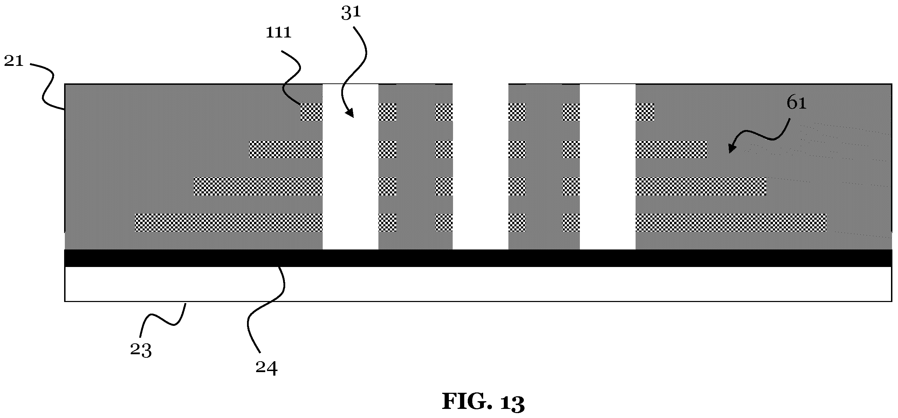

FIG. 13 shows a step of removing the second sacrificial material 41, i.e., removing the dummy memory hole plugs from the memory holes 31. For instance, if the dummy memory hole plugs are made of a-Si, they can be removed with tetramethylammonium hydroxide (TMAH), which is selective to oxide and metal. In particular, removing the second sacrificial material 41 comprises selectively etching the second sacrificial material 41, for example, selectively etching the a-Si with the TMAH and/or with phosphoric acid. Phosphoric acid might be useful to remove the top layer of a-Si, which is expected to be oxidized during the previous process steps. Generally, phosphoric acid might not be selective to the oxide material 22, therefore, the etch time should be limited and sufficient thickness margin of oxide material 22 should be provisioned to allow slight consumption during removal of the second sacrificial material 41.

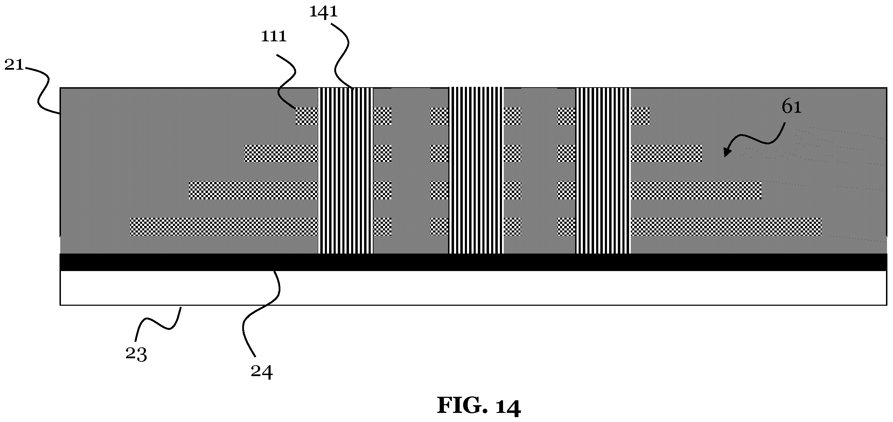

FIG. 14 shows a step of forming a respective memory structure 141 in each of the memory holes 31. After this, the second sacrificial material 41 in each memory hole 31 has effectively been replaced by the respective memory structure 141. Each memory structure 141 may comprise an oxide semiconductor material. Each memory structure 141 may additionally or alternatively comprise a ferroelectric material, for example, HZO.

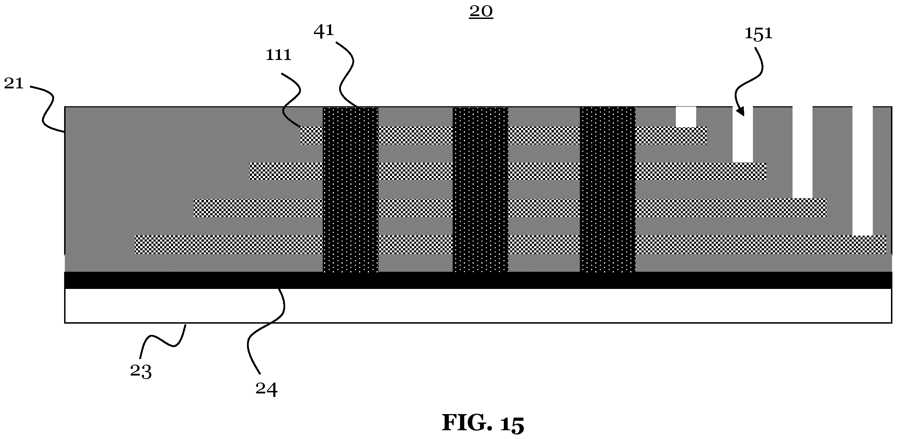

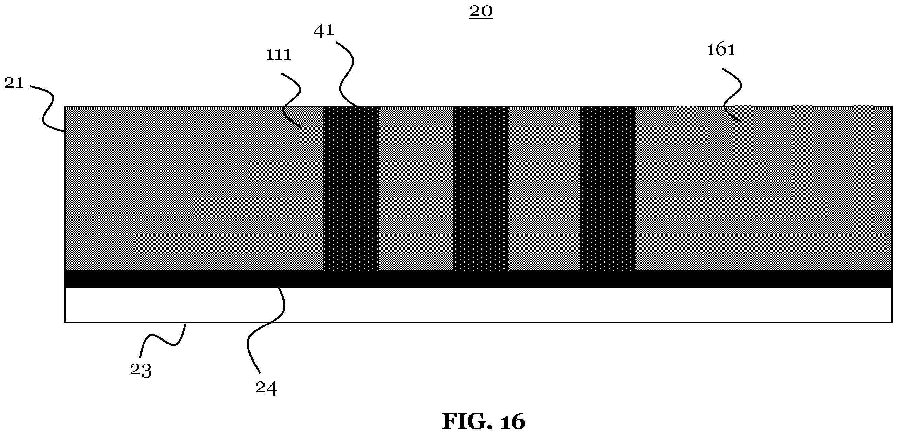

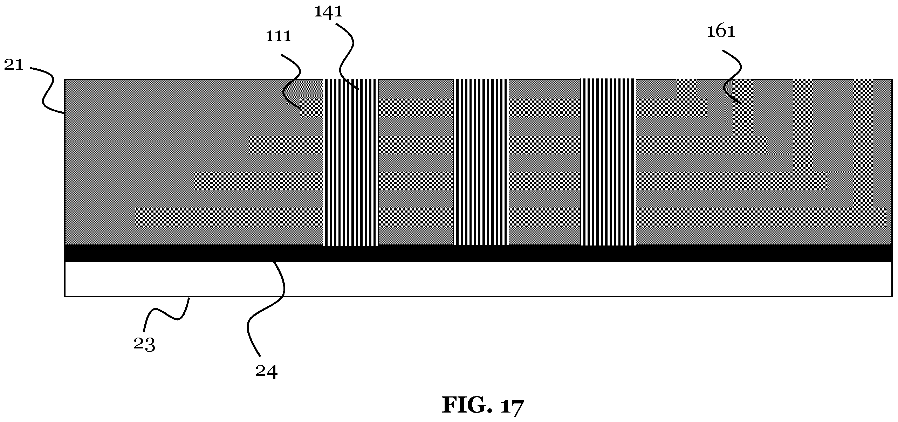

FIG. 15-17 shows an additional option for the fabrication method 10 of this disclosure, to form metal contacts. Fig. 15 relates to FIG. 7, and shows that before replacing the second sacrificial material 41 in each memory hole 31, a plurality of contact holes 151 may be formed, wherein the contact holes 151 reach to the plurality of metal layers 111. The contact holes 151 may be formed parallel to the stacking direction, but this is not a must. FIG. 16 further shows that the plurality of contact holes 151 are filled, for instance, with conducting or semiconducting material 161. For instance, they may be filled with the same material as the metal layers 111. Notably, FIG. 16 does not show the trenches 71, because preferably the contact holes 151 are in different planes than the memory holes 31, and thus the trenches 71. However, it is also possible to arrange the contact holes 151 and trenches 71 in the same plane, in which case the trenches 71 would be visible in FIG. 16. Finally FIG. 17 shows that the second sacrificial material 41, i.e. the dummy memory hole plugs, have been removed, which relates to the FIG. 13. A benefit of this additional option, which may be embedded into the process flow of FIGs. 2-14 is, that memory cells with less processing steps can be made, which can potentially lead to higher performance and stability of the memory device.

In summary of the above description of the drawings, the present disclosure proposes a RMG-first approach, accordingly a (ferroelectric) memory structure last approach. This approach creates the metal layers 111 (gates or electrodes) before deposition of the memory structures 141, particularly any ferroelectric material that is used.

As an exemplary wrap up of the fabrication method: The alternating stack of interlayer dielectric (e.g., silicon oxide) and first sacrificial material (e.g., silicon nitride) layers is deposited. Then, the memory holes 31 are etched into the stack and plugged with a dummy second sacrificial material 41, which is selective to the RMG process etch steps (e.g., amorphous silicon). The staircase structure 61 is formed for facilitating future metal connections. Then, RMG process steps are applied by replacing the second sacrificial material 41 with suitable work-function metal (e.g. TiN) or combinations of metals (e.g., TiN liner + W), and pulling back the deposited metal to form separated metal layers 111 (to be used as gates and/or word lines). The dummy second sacrificial material 41 should be selective to the first sacrificial material removal and the metal pull-back etch steps. It may also serve the anchoring purpose during the first sacrificial material replacement by the metal layers 111. The dummy second sacrificial material 41 is then selectively removed, for instance, with a wet chemical etch. Memory structures are formed, preferably with low thermal budget (TB), inside the memory holes 31. Optionally, an extra peripheral circuitry (e.g., vertical bit-line selectors comprising oxide semiconductor based transistors), may be formed inside the memory holes 31. The process may finish with standard BEOL modules (contact etch, metallization, end-of-line (EOL) treatment).

The memory structures suitable for low TB can be, for instance, oxide semiconductor (OSC)-based FeFETs, wherein the OSC is used as a channel and the replaced metal layers 111 play the role of a gates. Alternatively, a FeRAM element where a ferroelectric layer (combined with an OSC layer, if necessary) is deposited on the sidewall of a respective memory hole 31, wherein the RMG metal layers 111 act as plate-line electrodes and filler metal in the center of the memory holes 31 may act as bit-line electrodes. The use of the OSC allows to skip a high-temperature channel activation anneal, and the HfZrO₄-based ferroelectric materials offer low-temperature options with the crystallization temperature below 400°C.

Downstream process steps, which may continue the method 10 to form the desired memory device, may depend on the type of the memory device. Possible memory device implementations, with which the method 10 is suitable, include a 1T-nC 3D FeRAM (where "1T" represents one transistor and "nC" refers to the vertical string of n ferroelectric capacitors, "n" referring to the number of capacitors and can be 1 or more), which uses e.g. a Metal-Ferroelectric-Metal (MFM), Metal-Ferroelectric-Semiconductor-Metal (MFSM), or Metal-Ferroelectric-Insulator-Semiconductor-Metal (MFISM) structure, in order to leverage the ferroelectric properties for non-volatile memory storage. The method 10 is also applicable to vertical oxide semiconductor-channel FeFET-based 3D NAND, as well as ferroelectric Back-End-Of-Line (BEOL)-compatible 3D NAND FLASH, which allows for advanced integration and scalability in memory technologies.

Advantages of the method 10 presented in this disclosure are various. For instance, any stress-sensitive 3D device (e.g., also memory devices having air-gaps) can potentially benefit from having the suggested RMG-first approach. Extra process damage coming from performing the RMG process steps next to the memory elements can be eliminated. Moreover, active memory layers can be made with less processing steps and, hence, can avoid material property degradation due to exposure to a high thermal budget (>400°C), which can eventually lead to less variability and higher performance.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A method (10) for fabricating a memory device, particularly a ferroelectric memory device, the method (10) comprising:
depositing (11) a stack of a plurality of dielectric layers (21) and sacrificial layers (22), which are alternatingly arranged one on the other along a stacking direction, wherein the sacrificial layers (22) are made of a first sacrificial material;
forming (12) a plurality of memory holes (31) in the stack, wherein each memory hole (31) extends through each layer (21, 22) of the stack;
filling (13) each memory hole (31) with a second sacrificial material (41);
shaping (14) the stack to have a staircase structure (61) at opposite outer sides, wherein the staircase structure (61) is formed by the shaped stack having multiple concentric layer pairs of a dielectric layer (21) and a sacrificial layer (22), wherein a respective width of the layer pairs decreases continuously along the stacking direction;
after forming (12) the memory holes (31), replacing (15) each sacrificial layer (22) of the stack with a respective metal layer (111); and
after replacing (15) the sacrificial layers (22), replacing (16) the second sacrificial material (41) in each memory hole (31) with a respective memory structure (141);
wherein each memory structure (141) forms, in combination with the plurality of metal layers (111), a plurality of memory cells.

2. The method (10) according to claim 1, wherein the memory structures (141) are formed in the memory holes (31) at a temperature below 400 °C and/or the memory structures (141) are formed in the memory holes (31) and, subsequently, are not exposed to temperatures above 400 °C.

3. The method (10) according to claim 1 or 2, wherein the memory structures (141) comprise an oxide semiconductor material.

4. The method (10) according to one of the claims 1 to 3, wherein the memory structures (141) comprise a ferroelectric material, for example, hafnium zirconium oxide, HZO.

5. The method (10) according to one of the claims 1 to 4, wherein a memory cell comprises a ferroelectric capacitor or a ferroelectric field effect transistor, or is a flash memory cell or a ferroelectric flash memory cell.

6. The method (10) according to one of the claims 1 to 5, further comprising:
after filling (13) the memory holes (31) and before replacing (15) the sacrificial layers (22), forming one of more trenches (71) in the stack, wherein each trench (71) extends through each layer (21, 22) of the stack and is arranged between two or more of the memory holes (31); and
after replacing (15) the sacrificial layers (22), filling the one or more trenches (71) with a dielectric, semiconducting or conducting material.

7. The method (10) according to claim 6, wherein a portion of the stack is arranged between each trench (71) and the two or more memory holes (31) between which the trench (71) is arranged.

8. The method (10) according to one of the claims 1 to 7, further comprising:
before replacing (15) the second sacrificial material (41) in each memory hole (31), forming a plurality of contact holes (151) to the plurality of metal layers (111); and
filling the plurality of contact holes (151) with conducting or semiconducting material (161).

9. The method (10) according to one of the claims 1 to 8, wherein the first sacrificial material comprises silicon nitride or another nitride.

10. The method (10) according to one of the claims 1 to 9, wherein replacing (15) the sacrificial layers (22) with the metal layers (111) comprises selectively etching the first sacrificial material and/or depositing metal material to form the metal layers (111).

11. The method (10) according to claim 10, further comprising:
between selectively etching the first sacrificial material and depositing metal material to form the metal layers (111), forming one or more layers (101) of the memory structure (141) inside a cavity resulting from the etching, for example, by atomic layer deposition or area selective deposition;
wherein the one or more memory layers (101) comprise metal, semiconductor, ferroelectric, or dielectric material.

12. The method (10) according to one of the claims 1 to 11, wherein the second sacrificial material (41) comprises amorphous silicon.

13. The method (10) according to claim 12, wherein replacing the second sacrificial material (41) comprises selectively etching the second sacrificial material (41), for example, selectively etching the amorphous silicon with phosphoric acid and/or tetramethylammonium hydroxide.

14. A structure (20) suitable for building a memory device, particularly a ferroelectric memory device, the structure (20) comprising:
a stack of a plurality of metal layers (111) and dielectric layers (21), which are alternatingly arranged one on the other along a stacking direction,
wherein the stack has a shape of a staircase structure (61) at opposite outer sides of the stack, wherein the shape of the staircase structure (61) is formed by the stack having multiple concentric layer pairs of a dielectric layer (21) and a metal layer (111), wherein a respective width of the layer pairs decreases continuously along the stacking direction; and
a plurality of memory holes (31) in the stack, wherein each memory hole (31) extends through each layer (111, 21) of the stack, and wherein each memory hole (31) is filled with a sacrificial material (41), for example, amorphous silicon.

15. The structure (20) according to claim 14, further comprising a plurality of vertical contact holes (151) formed through the stack and filled with conducting or semiconducting material (161).
